# EUROPÄISCHE PATENTSCHRIFT

(11) **EP 3 447 820 B1**
(45) Veröffentlichungstag und Bekanntmachung des Hinweises auf die Patenterteilung: **05.05.2021**
(21) Anmeldenummer: 18184678.3
(22) Anmeldetag: 20.07.2018
(51) Int. Cl.: H01M 10/48, G01R 31/389, G01R 31/382, G01R 31/36, H01M 50/116, H01M 50/124, H01M 50/557

(54) **VERFAHREN ZUR BESTIMMUNG EINES ZUSTANDS ODER EINER ZUSTANDSÄNDERUNG EINER ELEKTROCHEMISCHEN ENERGIESPEICHERVORRICHTUNG**
METHOD FOR DETERMINING A STATE OR A CHANGE IN STATE OF AN ELECTROCHEMICAL ENERGY STORAGE DEVICE
PROCÉDÉ DE DÉTERMINATION D'UN ÉTAT OU D'UN CHANGEMENT D'ÉTAT D'UN DISPOSITIF ACCUMULATEUR D'ÉNERGIE ÉLECTROCHIMIQUE

(30) Priorität: 23.08.2017 DE 102017214770
(43) Veröffentlichungstag der Anmeldung: 27.02.2019
(73) Patentinhaber: VW Kraftwerk GmbH, 38440 Wolfsburg (DE); VARTA Microbattery GmbH, 73479 Ellwangen Jagst (DE)
(72) Erfinder: Huth, Andreas, 38159 Vechelde (DE); Keppeler, Ralf, 73463 Westhausen (DE); Schreiber, Werner, 38527 Meine (DE)
(74) Vertreter: Patentanwaltskanzlei Cartagena

(56) Entgegenhaltungen:
- WO-A1-2014/129855
- DE-A1-102011 120 505
- US-A1- 2009 246 607

## Beschreibung

Die nachfolgend beschriebene Erfindung betrifft ein Verfahren zur Bestimmung eines Zustands oder einer Zustandsänderung einer elektrochemischen Energiespeichervorrichtung mit einem Gehäuse aus einer mehrlagigen Verbundfolie.

Elektrochemische Energiespeichervorrichtungen weisen mindestens eine, häufig auch zwei oder mehr elektrochemische Energiespeicherzellen auf. Umfasst eine elektrochemische Energiespeichervorrichtung mehrere Energiespeicherzellen, so sind diese in aller Regel parallel und/oder seriell miteinander verschaltet. Eine elektrochemische Energiespeicherzelle umfasst ihrerseits eine Anordnung aus mindestens einer positiven und mindestens einer negativen Elektrode und einem dazwischen angeordneten Separator, im einfachsten Fall aus genau einer positiven Elektrode, genau einer negativen Elektrode und genau einem dazwischen angeordneten Separator.

Bei der Entladung einer elektrochemischen Energiespeicherzelle findet eine energieliefernde chemische Reaktion statt, welche sich aus zwei elektrisch miteinander gekoppelten aber räumlich voneinander getrennten Teilreaktionen zusammensetzt. Eine bei vergleichsweise niedrigerem Redoxpotential stattfindende Teilreaktion läuft an der negativen Elektrode ab, eine bei vergleichsweise höherem Redoxpotential an der positiven Elektrode. Bei der Entladung werden an der negativen Elektrode durch einen Oxidationsprozess Elektronen freigesetzt, resultierend in einem Elektronenstrom - meist über einen äußeren Verbraucher - zur positiven Elektrode, von der eine entsprechende Menge an Elektronen aufgenommen wird. An der positiven Elektrode findet also ein Reduktionsprozess statt. Zeitgleich kommt es zu einem der Elektrodenreaktion entsprechenden lonenstrom innerhalb der Zelle. Dieser lonenstrom wird durch einen ionisch leitenden Elektrolyten gewährleistet. In sekundären elektrochemischen Energiespeicherzellen ist diese Entladereaktion reversibel, es besteht also die Möglichkeit, die bei der Entladung erfolgte Umwandlung chemischer Energie in elektrische umzukehren. Werden in diesem Zusammenhang die Begriffe Anode und Kathode benutzt, benennt man die Elektroden in der Regel entsprechend ihrer Entladefunktion. Die negative Elektrode ist in solchen Energiespeicherzellen also die Anode, die positive Elektrode die Kathode.

Unter den bekannten sekundären elektrochemischen Energiespeicherzellen werden vergleichsweise hohe Energiedichten insbesondere von Energiespeicherzellen auf Lithium-Ionen-Basis erreicht. Die Elektroden von Energiespeicherzellen auf Lithium-Ionen-Basis liegen meist schichtförmig vor. Gemeinsam mit mindestens einer Separatorschicht bilden sie einen Verbund aus flachen Elektroden-und Separatorschichten. Der Verbund kann spiralförmig aufgewickelt sein. In vielen Fällen sind die Elektroden und der mindestens eine Separator aber auch flach aufeinander gestapelt. Insbesondere können in einer Energiespeichervorrichtung auch mehrere Energiespeicherzellen auf Lithium-Ionen-Basis aufeinander gestapelt vorliegen.

Die Elektroden sekundärer elektrochemischer Energiespeicherzellen auf Lithium-Ionen-Basis umfassen üblicherweise metallische Stromkollektoren, die meist in Form von Folien, Netzen, Gittern, Schäumen, Vliesen oder Filzen vorliegen. Im Fall der positiven Elektrode werden als Stromkollektoren meist Netze oder Folien aus Aluminium, beispielsweise aus Aluminiumstreckmetall oder aus einer Aluminiumfolie, eingesetzt. Auf der Seite der negativen Elektrode werden als Stromkollektoren meist Netze oder Folien aus Kupfer verwendet.

In der Regel werden Energiespeicherzellen auf Lithium-Ionen-Basis in einem mehrstufigen Verfahren produziert. Üblich ist, dass in einem ersten Schritt die schichtförmigen Elektroden hergestellt werden, die dann anschließend mit einem oder mehreren Separatoren zu den erwähnten Elektroden-Separator-Verbünden kombiniert werden. Zur Herstellung einer Energiespeicherzelle können Elektroden und Separatoren lose gestapelt oder gewickelt werden oder auch in einem Laminationsschritt miteinander verbunden werden. Abschließend werden die hergestellten Zellen meist in ein flüssigkeitsdichtes Gehäuse verpackt und mit einem Elektrolyten getränkt.

Zur Herstellung der schichtförmigen Elektroden werden aus meist pastenförmigen Zusammensetzungen, die ein geeignetes elektrochemisch aktives Material (kurz "Aktivmaterial") umfassen, auf den Stromkollektoren dünne Elektrodenfilme gebildet, beispielsweise mittels eines Rakel oder mittels einer Breitschlitzdüse (slot die). Für die Elektroden einer Energiespeicherzelle auf Lithium-Ionen-Basis geeignete Aktivmaterialien müssen Lithium-Ionen aufnehmen und wieder abgeben können, die beim Laden bzw. Entladen von der negativen zur positiven Elektrode (und umgekehrt) wandern.

Als für negative Elektroden von Energiespeicherzellen auf Lithium-Ionen-Basis geeignete Aktivmaterialien kommen insbesondere graphitischer Kohlenstoff oder zur Interkalation von Lithium befähigte nicht-graphitische Kohlenstoffmaterialien in Frage. Weiterhin können auch metallische und halbmetallische Materialien, die mit Lithium legierbar sind, zum Einsatz kommen. So sind beispielsweise die Elemente Zinn, Antimon und Silizium in der Lage, mit Lithium intermetallische Phasen zu bilden. Insbesondere können die kohlenstoffbasierten Aktivmaterialien mit den metallischen und/oder halbmetallischen Materialien auch kombiniert werden.

Für die positiven Elektroden eignet sich insbesondere Lithiumkobaltoxid (LCO) mit der Summenformel LiCoO₂, Lithiumnickelmangancobaltoxid (NMC) mit der Summenformel LiNiₓMn_{y}Co_{z}O₂, Lithiummanganspinell (LMO) mit der Summenformel LiMn₂O₄, Lithiumeisenphosphat (LFP) mit der Summenformel LiFePO₄ oder Lithiumnickelcobaltaluminiumoxid mit der Summenformel LiNiₓCo_{y}Al_{z}O₂ (NCA). Auch Mischungen der genannten Materialien können eingesetzt werden.

Neben den Aktivmaterialien enthalten die Zusammensetzungen in der Regel noch einen Elektrodenbinder, einen Leitfähigkeitsverbesserer, ein Lösungs- und/oder Suspensionsmittel sowie ggf. noch Additive, beispielsweise zur Beeinflussung ihrer Verarbeitungseigenschaften. Ein Elektrodenbinder bildet eine Matrix, in die das Aktivmaterial sowie gegebenenfalls der Leitfähigkeitsverbesserer eingelagert sein können. Die Matrix soll für eine erhöhte strukturelle Stabilität während durch die Lithiierung und Delithiierung verursachten Volumenexpansionen und -kontraktionen sorgen. Als Lösungs- und/oder Suspensionsmittel kommen z.B. Wasser oder organische Lösungsmittel wie N-Methyl-2-Pyrrolidon (NMP) oder N-Ethyl-2-Pyrrolidon (NEP) in Frage. Ein Beispiel für einen wässrig prozessierbaren Binder ist Natrium-Carboxymethylzellulose (Na-CMC). Ein Beispiel für einen in organischen Lösungsmitteln prozessierbaren Binder ist Polyvinylidendifluorid (PVDF). Als Additive können z.B. Rheologiehilfsmittel zugesetzt werden. Bei dem Leitfähigkeitsverbesserer handelt es sich meist um ein elektrisch leitfähiges kohlenstoffbasiertes Material, insbesondere um Leitruß, Leitgraphit, Kohlenstofffasern oder Kohlenstoffröhrchen.

In der Zusammensetzung enthaltenes Lösungs- und/oder Suspensionsmittel findet sich üblicherweise in den auf den Stromkollektoren gebildeten Elektrodenfilmen wieder und muss aus diesen entfernt werden. Die trockenen Elektrodenfilme können dann verdichtet werden, beispielsweise in einem Kalandrierprozess. Die so gebildeten Elektroden können zu den erwähnten Energiespeicherzellen auf Lithium-Ionen-Basis verbaut werden, welche wiederum zu Energiespeichervorrichtungen verbaut werden können.

Bei der Herstellung einer Energiespeichervorrichtung auf Lithium-Ionen-Basis können eine oder mehrere Energiespeicherzellen auf Lithium-Ionen-Basis in ein Gehäuse aus einer mehrlagigen Verbundfolie verpackt werden. Typischerweise wird ein solches Gehäuse aus zwei aus der Verbundfolie bestehenden Gehäuseteilen zusammengesetzt. Diese werden beispielsweise über eine Klebe- oder Siegelschicht dichtend miteinander verbunden, so dass im Wesentlichen keine Feuchtigkeit von außen in das Gehäuse eindringen und gegebenenfalls im Gehäuse enthaltener Flüssigelektrolyt nicht austreten kann. Besonders bevorzugt handelt es sich bei den Gehäusefolien um Aluminium-Verbundfolien, beispielsweise mit der Sequenz Polyamid/Aluminium/Polypropylen.

Vor dem Schließen des Gehäuses wird die mindestens eine Energiespeichervorrichtung mit einem geeigneten Elektrolyten getränkt. Für Energiespeicherzellen auf Lithium-Ionen-Basis wird ein organischer Elektrolyt benötigt, beispielsweise auf Basis organischer Carbonate.

In Folge einer mechanischen Schädigung oder unsachgemäßen Behandlung einer Energiespeicherzelle auf Lithium-Ionen-Basis kann diese einen irregulären Zustand (Zelltemperatur > maximale Betriebstemperatur, Elektrolytzersetzung) erreichen, in dem die Betriebssicherheit nicht mehr gewährleistet ist. Es ist wichtig, solchen irregulären Zustände rechtzeitig zu erkennen, um betroffene Zellen gegebenenfalls abschalten zu können.

Aus der US 2009/0246607 A1 ist eine Batterie mit einem Gehäuse bekannt, das aus zwei Gehäuseteilen besteht, die aus einer mehrlagigen Metall/Kunststoff-Verbundfolie, die eine innenliegende Metallschicht aufweist, gefertigt sind. Die Gehäuseteile sind in Randbereichen derart miteinander verschweißt, dass ein unmittelbarer elektrischer Kontakt zwischen den Metallschichten der Folien gebildet wird. Die so gebildete Kontaktzone kann als Sensor für irreguläre Zustände dienen. Entsteht im Gehäuse der Batterie ein irregulärer Überdruck, so kann die Kontaktzone zerstört werden so dass der elektrische Kontakt zwischen den Metallschichten der Folien abreißt. Ein dabei auftretender Spannungsabfall kann detektiert werden, ein hierfür erforderliches Messgerät kann mit den Metallschichten elektrisch verbunden werden.

Aus der DE 102011120505 A1 sind Energiespeichervorrichtungen bekannt, die jeweils Gehäuse aus mehrlagigen Metall/Kunststoff-Verbundfolien aufweisen. Dabei weisen einzelne Gehäuseteile einen Kontaktbereich auf, an den ein elektrischer Leiter angekoppelt werden kann. Um Beschädigungen der Kunststoffschichten der mehrlagigen Gehäusefolie detektieren zu können, werden elektrische Spannungen zwischen den Metallschichten der Gehäuseteile und den Elektroden gemessen.

Die WO 2014/129855 A1 betrifft ähnlich wie die DE 102011120505 A1 eine Energiespeichervorrichtung, die ein Gehäuse aus einer mehrlagigen Metall/Kunststoff-Verbundfolie aufweist. In das Gehäuse ist ein Isolationswiderstandsmesssystem integriert. In den äußeren Gehäusefolien sind Aussparungen vorgesehen, so dass eine innenliegende Metallschicht von außen elektrisch kontaktiert werden kann, um Beschädigungen der Kunststoffschichten der mehrlagigen Gehäusefolie detektieren zu können. Dabei werden, wiederum ähnlich wie in der DE 102011120505 A1 beschrieben, elektrische Spannungen zwischen den Metallschichten der Gehäuseteile und den Elektroden gemessen.

Der vorliegenden Erfindung lag die Aufgabe zugrunde, eine einfache technische Lösung bereitzustellen, um Zustände oder Zustandsänderungen einer elektrochemischen Energiespeichervorrichtung bestimmen zu können.

Zur Lösung dieser Aufgabe schlägt die Erfindung das Verfahren mit den in Anspruch 1 genannten Merkmalen vor.

Das erfindungsgemäße Verfahren dient der Bestimmung eines Zustands oder einer Zustandsänderung einer elektrochemischen Energiespeichervorrichtung, welche sich durch die folgenden Merkmale auszeichnet:
- Die Energiespeichervorrichtung umfasst einen Verbund aus mindestens einer positiven schichtförmigen Elektrode, mindestens einer negativen schichtförmigen Elektrode und mindestens einer Separatorschicht.
- Die Energiespeichervorrichtung umfasst ein Gehäuse aus einer mehrlagigen Verbundfolie.
- Das Gehäuse umfasst ein erstes und ein zweites Gehäuseteil aus der mehrlagigen Verbundfolie, die, vorzugsweise an ihren Rändern, miteinander verbunden sind und gemeinsam einen Hohlraum einschließen, in dem derVerbund angeordnet ist.
- Die Verbundfolie umfasst eine Lage aus einer bevorzugt durchgängigen Metallschicht sowie zwei Lagen aus Kunststoff, wobei die Metallschicht zwischen den zwei Kunststofflagen angeordnet ist.
- die Metallschicht des ersten Gehäuseteils und die Metallschicht des zweiten Gehäuseteils sind gegeneinander elektrisch isoliert.

Besonders bevorzugt ist die Energiespeichervorrichtung eine Energiespeichervorrichtung auf Lithium-Ionen-Basis, weist also mindestens eine Energiespeicherzelle mit mindestens einer Lithium interkalierenden Elektrode auf.

Energiespeichervorrichtungen mit diesen Merkmalen sind - wie aus den obigen einleitenden Ausführungen hervorgeht - aus dem Stand der Technik bereits bekannt. Grundsätzlich ist das erfindungsgemäße Verfahren auf alle bekannten Lithium-lonen-basierte Energiespeichervorrichtungen anwendbar. Voraussetzung ist lediglich, dass die Energiespeichervorrichtungen ein Gehäuse aus einer mehrlagigen Verbundfolie mit einer Lage aus einer Metallschicht, wie es hier definiert ist, aufweisen.

Erfindungsgemäß wird zur Bestimmung des Zustands oder der Zustandsänderung der Energiespeichervorrichtung eine elektrische Spannung an die Metallschichten des ersten und des zweiten Gehäuseteils angelegt. Hierbei macht man sich zunutze, dass die Metallschichten des ersten und des zweiten Gehäuseteils, die, da sie ja gegeneinander elektrisch isoliert sind, als Elektroden eines Kondensators fungieren und elektrische Energie statisch speichern können. Beim Verbinden der Metallschichten mit den Polen einer Spannungsquelle werden Elektronen von einer der Metallschichten abgezogen und auf der anderen Metallschicht angereichert, was bedeutet, dass eine elektrische Ladung Q von der einen auf die andere Metallschicht verlagert wird. Durch diese Verlagerung wird ein elektrisches Feld E zwischen den Metallschichten aufgebaut. Sobald das Feld aufgebaut ist, lässt sich eine elektrische Größe bestimmen, die durch eine Änderung eines Abstands zwischen den Metallschichten beeinflusst wird.

Besonders bevorzugt erfolgt die Bestimmung des Zustands oder der Zustandsänderung der Energiespeichervorrichtung auf einem der drei folgenden Wege:
- Es wird als elektrische Größe eine elektrische Kapazität zwischen der Metallschicht des ersten und der Metallschicht des zweiten Gehäuseteils oder eine Änderung dieser Kapazität bestimmt.
- Es wird als elektrische Größe eine zwischen den Metallschichten herrschende elektrische Spannung oder eine Änderung dieser Spannung bestimmt.
- Es wird als elektrische Größe eine kapazitive Impedanz der das elektrische Feld bildenden Metallschichten oder eine Änderung dieser Impedanz bestimmt.

Alle diese elektrischen Größen hängen mittelbar oder unmittelbar davon ab, in welchem Abstand sich die Metallschichten zueinander befinden. Daraus ergibt sich, dass sich aus einer Änderung dieser Größen auf eine Änderung des Abstands zwischen den Metallschichten rückschließen lässt.

Bekanntlich sind die funktionellen Eigenschaften eines Kondensators, insbesondere seine Kapazität, von einer Reihe von Parametern abhängig, so etwa
- Der Temperatur des Kondensators,
- der Fläche der Elektroden des Kondensators,
- dem Abstand der Elektroden des Kondensators und
- der Dielektrizitätszahl eines zwischen den Elektroden angeordneten Dielektrikums.

Vorliegend befinden sich zwischen den Metallschichten des ersten und des zweiten Gehäuseteils zumindest zwei Lagen aus Kunststoff. Sowohl die Dicke dieser Kunststoffschicht als auch ihre Beschaffenheit hat somit Einfluss auf die Kapazität eines aus den zwei Metallschichten gebildeten Kondensators.

Ändert sich beispielsweise der Abstand der Metallschichten, so hat dies Auswirkungen auf eine zwischen den Metallschichten anliegende Spannung. Eine Spannungsänderung kann detektiert werden und lässt einen entsprechenden Rückschluss auf eine Änderung des Abstands der Metallschichten zu. Analoges gilt für die Kapazität sowie für die kapazitive Impedanz der das elektrische Feld bildenden Metallschichten. Eine Änderung der Kapazität oder der Impedanz kann auf eine Änderung des Abstands der Metallschichten hinweisen.

Die Bestimmung der Kapazität kann gemäß bekannten Vorgehensweisen erfolgen, insbesondere nach einer der folgenden Vorgehensweisen:
- Laden der zwei Metallschichten mit konstantem Strom und Beobachten der Spannungsanstiegsgeschwindigkeit
- Messen der Resonanzfrequenz eines mit der Kapazität gebildeten LC-Schwingkreises
- Anlegen einer Wechselspannung und Messen des Stromverlaufes

Die letztgenannte Vorgehensweise eignet sich auch zur Bestimmung kapazitiver Impedanzen. Sie findet in vielen käuflichen Kapazitätsmessgeräten Anwendung. Zur Anwendung in einem erfindungsgemäßen Verfahren eignen sich handelsübliche Multimeter oder jedes andere hierfür geeignete Messgerät.

In einer bevorzugten Ausführungsform des erfindungsgemäßen Verfahrens handelt es sich bei dem zu bestimmenden Zustand um einen Ladezustand der elektrochemischen Energiespeichervorrichtung. Die Elektroden elektrochemischer Energiespeichervorrichtungen, insbesondere von Energiespeichervorrichtungen auf Lithium-Ionen-Basis, unterliegen im Betrieb bei Lade- und Entladevorgängen nicht unerheblichen Volumenänderungen. Das bedeutet, dass sich die äußeren Dimensionen von Energiespeichervorrichtungen beim Laden- und Entladen ändern können. Bei Energiespeichervorrichtungen mit einem Gehäuse aus zwei Gehäuseteilen aus einer mehrlagigen Verbundfolie stehen die Gehäuseteile häufig in unmittelbarem zweidimensionalem Kontakt zu den Elektroden. Dehnt sich eine Elektrode während eines Ladevorgangs aus, so ändert eine an der Elektrode anliegende Gehäusefolie ihre Position. Im Mittel verändert sich dadurch der Abstand zwischen den Gehäuseteilen und den darin enthaltenen Metallschichten. Dies hat, wie oben dargelegt, unmittelbaren Einfluss auf ein zwischen den Metallschichten existierendes elektrisches Feld. Konsequenterweise lassen sich beispielsweise gemessene Kapazitätswerte mit mittleren Abständen von Gehäusefolien und mit Ladezuständen von elektrochemischen Energiespeichervorrichtungen verknüpfen.

In einer weiteren bevorzugten Ausführungsform des erfindungsgemäßen Verfahrens handelt es sich bei dem zu bestimmenden Zustand um einen irregulären Zustand in Folge einer Temperaturerhöhung oder einer Gasung der elektrochemischen Energiespeichervorrichtung. Solche irregulären Zustände treten im Betrieb insbesondere nach mechanischen Defekten oder Überladungen auf. Temperaturerhöhungen führen zu einer thermischen Ausdehnung von Elektroden und Elektrolyt und entsprechend zu einem Anschwellen von Verbundfoliengehäusen. Gasungen, etwa in Folge von Elektrolytzersetzungen, führen zum gleichen Ergebnis. Die hiermit verbundenen Änderungen der Abstände von Gehäuseteilen lassen sich wiederum leicht durch Messung von Kapazitäts-, Impedanz- oder Spannungsänderungen detektieren.

In einer weiteren bevorzugten Ausführungsform des erfindungsgemäßen Verfahrens handelt es sich bei dem zu bestimmenden Zustand um eine Temperatur der elektrochemischen Energiespeichervorrichtung. Temperaturerhöhungen treten nicht zwingend als Folge eines irregulären Zustands auf. Vielmehr kommt es im Normalbetrieb regelmäßig zu Temperaturschwankungen, beispielsweise bei Ladevorgängen. Auch solche Temperaturschwankungen sind erfindungsgemäß detektierbar und quantifizierbar.

Das erfindungsgemäße Verfahren lässt sich allerdings nicht nur einsetzen, um Parameter zu überwachen, die im laufenden Betrieb elektrochemischer Energiespeichervorrichtungen von Interesse sein können. Vielmehr kann es bereits bei der Produktion der Energiespeichervorrichtungen von Nutzen sein, etwa bei der Überwachung der Einhaltung von Produktionsparametern.

In einer bevorzugten Ausführungsform des erfindungsgemäßen Verfahrens handelt es sich bei dem zu bestimmenden Zustand um den qualitativen Zustand einer Klebe- oder Siegelschicht zwischen dem ersten und dem zweiten Gehäuseteil: Wie eingangs bereits ausgeführt wurde, werden bei der Herstellung von Verbundfoliengehäusen die zu kombinierenden Gehäuseteile gegebenenfalls über eine Klebe- oder Siegelschicht miteinander verbunden. Die Dicke dieser Klebe- und Siegelschicht bestimmt gegebenenfalls auch den Abstand zwischen den zwei Metallschichten. Je dünner die Klebe- und Siegelschicht, desto geringer der Abstand. Produktionsbedingt kann es vorkommen, dass eine Klebe- und Siegelschicht zu dünn oder zu dick gebildet wird. Dies lässt sich gemäß der vorliegenden Erfindung detektieren.

Analoges gilt für den qualitativen Zustand der Lagen aus Kunststoff der Verbundfolie des ersten oder des zweiten Gehäuseteils. Weisen die Lagen etwa ungleichmäßige Dicken oder Fehlstellen auf, so wirkt sich dies auf den Abstand zwischen den Metallschichten aus. In einer weiteren bevorzugten Ausführungsform des erfindungsgemäßen Verfahrens handelt es sich daher bei dem zu bestimmenden Zustand um den qualitativen Zustand der Lagen aus Kunststoff der Verbundfolie des ersten oder des zweiten Gehäuseteils.

Eine elektrochemische Energiespeichervorrichtung, die sich zur Durchführung des Verfahrens eigent, zeichnet sich durch die folgenden Merkmale aus:
- Sie umfasst einen Verbund aus mindestens einer positiven schichtförmigen Elektrode, mindestens einer negativen schichtförmigen Elektrode und mindestens einer Separatorschicht.
- Sie umfasst ein Gehäuse aus einer mehrlagigen Verbundfolie.
- Das Gehäuse umfasst ein erstes und ein zweites Gehäuseteil aus der mehrlagigen Verbundfolie, die, vorzugsweise an ihren Rändern, miteinander verbunden sind und gemeinsam einen Hohlraum einschließen, in dem derVerbund angeordnet ist.
- Die Verbundfolie umfasst eine Lage aus einer Metallschicht sowie zwei Lagen aus Kunststoff, wobei die Metallschicht zwischen den zwei Kunststofflagen angeordnet ist

Zur Durchführung des Verfahrens weist die elektrochemische Energiespeichervorrichtung spezielle Modifikationen auf. Sie zeichnet sich dadurch aus, dass
- die Gehäuseteile jeweils einen Kontaktbereich zur elektrischen Ankopplung eines elektrischen Leiters an die jeweilige Metallschicht umfassen.

Die Kontaktbereiche dienen dazu, die erforderliche elektrische Spannung an die Metallschichten des ersten und des zweiten Gehäuseteils anlegen zu können. Insbesondere dienen sie dazu, über elektrische Kontakte ein Messgerät an die Metallschichten anschließen zu können, um die elektrische, durch eine Änderung eines Abstands zwischen den Metallschichten beeinflussbare Größe zu bestimmen

Betreffend mögliche bevorzugte Ausführungsformen der mindestens einen positiven Elektrode, der mindestens einen negativen Elektrode und der mindestens einen Separatorschicht sowie des Gehäuses aus der mehrlagigen Verbundfolie und der Gehäuseteile wird auf die einleitenden Erläuterungen zu bekannten Energiespeichervorrichtungen auf Lithium-Ionen-Basis und deren Komponenten Bezug genommen. So umfasst die Energiespeichervorrichtung bevorzugt eine, besonders bevorzugt auch mehrere der eingangs beschriebenen Energiespeicherzellen auf Lithium-Ionen-Basis. Gegebenenfalls liegen diese innerhalb des Gehäuses aufeinander gestapelt vor.

Bei den Metallschichten handelt es sich besonders bevorzugt um Aluminiumschichten. Bei den Lagen aus Kunststoff handelt es sich beispielsweise um Polyamid und Polypropylen.

Bevorzugt zeichnet sich die elektrochemische Energiespeichervorrichtung durch mindestens eines der folgenden zusätzlichen Merkmale aus:
- Die Metallschicht weist zwei Flachseiten und einen umlaufenden Rand auf.
- Die Metallschicht weist eine im Wesentlichen konstante Dicke auf.
- Mindestens einer der Kontaktbereiche ist ein Bereich auf einer der zwei Flachseiten, der nicht von einer Kunststofflage bedeckt ist.
- Mindestens einer der Kontaktbereiche ist eine Fläche auf einem separaten metallischen Anschlusskontakt, der mit dem umlaufenden Rand der Metallschicht oder einer ihrer Flachseiten elektrisch verbunden ist, insbesondere durch Verschweißung.
- Mindestens einer der Kontaktbereiche ist eine Fläche auf mindestens einem separaten metallischen Anschlusskontakt, der die Verbundfolie eines der Gehäuseteile durchstößt und dabei die enthaltene Metallschicht elektrisch kontaktiert.

In der Regel entspricht die Größe der zwei Flachseiten exakt der Größe der Gehäuseteile, die zusammen das Gehäuse der Energiespeichervorrichtung bilden. Die Dicke der Metallschicht liegt bevorzugt im Bereich zwischen 20 und 100 µm. Die Verbundfolie weist bevorzugt insgesamt eine Dicke im Bereich zwischen 70 und 300 µm auf. Die Dicke der Kunststofflagen, die die Metallschicht abdecken, liegt bevorzugt im Bereich zwischen 25 und 100 µm.

Es ist von Vorteil, wenn der Kontaktbereich eine zweidimensionale Fläche umfasst, an die ein elektrischer Leiter angepresst werden kann, um einen zuverlässigen elektrischen Kontakt herzustellen. Bevorzugt ist die Fläche mindestens 1 mm², bevorzugt mindestens 4 mm², besonders bevorzugt mindestens 16 mm², insbesondere mindestens 25 mm², groß.

Zur Bereitstellung eines Kontaktbereichs kann beispielsweise eine der Kunststofflagen der Verbundfolie bereichsweise von der Metallschicht entfernt werden. Weiterhin kann an die Metallschicht der separate metallische Anschlusskontakt angeformt werden, beispielsweise mittels Verschweißung.

Bei dem separaten Anschlusskontakt, der die Verbundfolie durchstößt, kann es sich beispielsweise um eine Nadel oder einen Nagel handeln.

Insbesondere wenn die Energiespeichervorrichtung mehr als eine Energiespeicherzelle umfasst, weist sie in bevorzugten Ausführungsformen einen elektrischen Leiter auf, der mit der mindesten einen positiven Elektrode elektrisch verbunden und aus dem Hohlraum herausgeführt ist, sowie einen elektrischen Leiter, der mit der mindestens einen negativen Elektrode elektrisch verbunden und aus dem Hohlraum herausgeführt ist. Diese Leiter sind in bevorzugten Ausführungsformen durch eine Siegelschicht nach außen geführt

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung bevorzugter Ausführungsformen der Erfindung sowie anhand der Zeichnung. Hierbei zeigt schematisch:

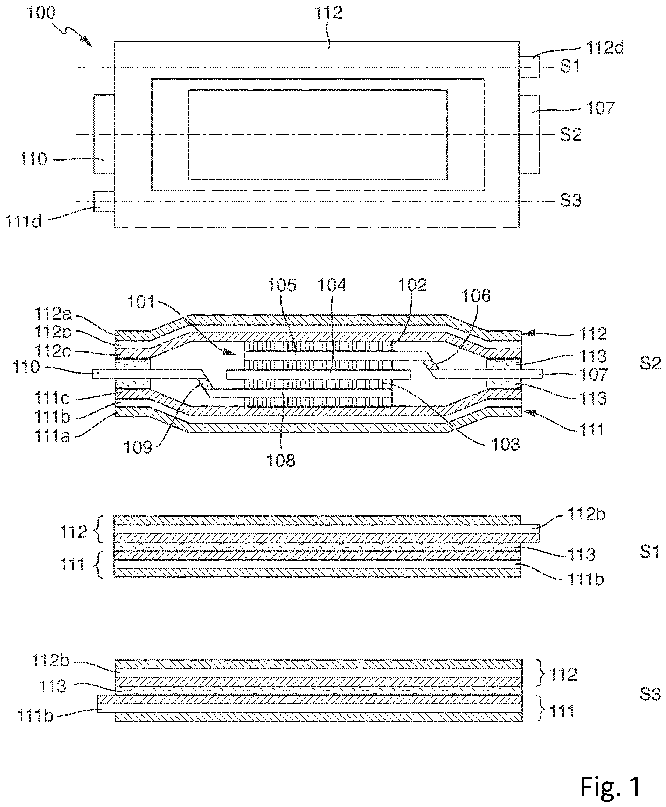

Figur 1 eine Illustration (Draufsicht senkrecht von oben) einer Ausführungsform einer zur Durchführung des erfindungsgemäßen Verfahrens geeigneten Energiespeichervorrichtung sowie dreier Schnitte durch diese Ausführungsform.

Die in Fig. 1 dargestellte Energiespeichervorrichtung 100 umfasst einen Verbund 101 aus mindestens einer positiven schichtförmigen Elektrode 102, mindestens einer negativen schichtförmigen Elektrode 103 und mindestens einer Separatorschicht 104, die zwischen den Elektroden 102 und 103 angeordnet ist. In die positive schichtförmige Elektrode 102 ist der Stromkollektor 105 eingebettet, der beidseitig mit Aktivmaterial bedeckt ist. Über die Schweißverbindung 106 ist er mit dem elektrischen Leiter 107 verbunden. In die negative schichtförmige Elektrode 103 ist der Stromkollektor 108 eingebettet, der beidseitig mit Aktivmaterial bedeckt ist. Über die Schweißverbindung 109 ist er mit dem elektrischen Leiter 110 verbunden. Der Verbund 101 ist in einem Hohlraum angeordnet, der von einem ersten Gehäuseteil 111 und einem zweiten Gehäuseteil 112 gebildet wird. Die Gehäuseteile 111 und 112 bestehen jeweils aus einer mehrlagigen Verbundfolie. Im Falle des Gehäuseteils 111 umfasst diese die Metallschicht 111b sowie die Kunststofflagen 111a und 111c. Im Falle des Gehäuseteils 112 umfasst diese die Metallschicht 112b sowie die Kunststofflagen 112a und 112c. An ihren Rändern sind die Gehäuseteile 111 und 112 über die Siegelschicht 113 miteinander verbunden. Die elektrischen Leiter 107 und 110 sind jeweils aus dem von den Gehäuseteilen 111 und 112 gebildeten Gehäuse herausgeführt. Über sie können die Elektroden 102 und 103 von außerhalb des Gehäuses elektrisch kontaktiert werden.

Die Gehäuseteile 111 und 112 umfassen jeweils einen Kontaktbereich 111d und 112d zur elektrischen Ankopplung eines elektrischen Leiters an die jeweilige Metallschicht 111b und 112b. Zur Bereitstellung der Kontaktbereiche 111d und 112d wurden die Kunststofflagen 111a und 112a der bereichsweise von den Metallschichten 111b und 112b entfernt. Die Position der Kontaktbereiche kann je nach Bedarf variiert werden. So können die Kontaktbereiche 111d und 112d beispielsweise beide an einer Seite des aus den Gehäuseteilen 111 und 112 gebildeten Gehäuses positioniert sein.

Legt man an die Kontaktbereiche 111d und 112d eine elektrische Spannung an, so bildet sich zwischen den Metallschichten 111b und 112b ein elektrisches Feld. Die Metallschichten 111b und 112b verhalten sich näherungsweise wie die Platten eines Plattenkondensators.

## Patentansprüche

1. Verfahren zur Bestimmung eines Zustands oder einer Zustandsänderung einer elektrochemischen Energiespeichervorrichtung (100) mit den Merkmalen
a. die Energiespeichervorrichtung umfasst einen Verbund (101) aus mindestens einer positiven schichtförmigen Elektrode (102), mindestens einer negativen schichtförmigen Elektrode (103) und mindestens einer Separatorschicht (104),
b. die Energiespeichervorrichtung umfasst ein Gehäuse aus einer mehrlagigen Verbundfolie,
c. das Gehäuse umfasst ein erstes und ein zweites Gehäuseteil (111; 112) aus der mehrlagigen Verbundfolie, die, vorzugsweise an ihren Rändern, miteinander verbunden sind und gemeinsam einen Hohlraum einschließen, in dem der Verbund (101) angeordnet ist,
d. die Verbundfolie umfasst eine Lage aus einer Metallschicht (111b; 112b) sowie zwei Lagen aus Kunststoff (111a, 111c; 112a, 112c), wobei die Metallschicht (111b; 112b) zwischen den zwei Kunststofflagen (111a, 111c; 112a, 112c) angeordnet ist, und
e. die Metallschicht (111b) des ersten Gehäuseteils (111) und die Metallschicht (112b) des zweiten Gehäuseteils (112) sind gegeneinander elektrisch isoliert,
wobei
f. zur Bestimmung des Zustands oder der Zustandsänderung eine elektrische Spannung an die Metallschichten (111b; 112b) des ersten und des zweiten Gehäuseteils (111; 112) angelegt wird, so dass ein elektrisches Feld zwischen den Metallschichten (111b; 112b) entsteht, und eine elektrische Größe bestimmt wird, die durch eine Änderung eines Abstands zwischen den Metallschichten (111b; 112b) beeinflusst wird.

2. Verfahren nach Anspruch 1 mit mindestens einem dem folgenden zusätzlichen Schritte:
a. Zur Bestimmung des Zustands oder der Zustandsänderung wird als elektrische Größe eine elektrische Kapazität zwischen der Metallschicht (111b) des ersten und der Metallschicht (112b) des zweiten Gehäuseteils oder eine Änderung dieser Kapazität bestimmt.
b. Zur Bestimmung des Zustands oder der Zustandsänderung wird als elektrische Größe eine zwischen den Metallschichten (111b; 112b) herrschende elektrische Spannung oder eine Änderung dieser Spannung bestimmt.
c. Zur Bestimmung des Zustands oder der Zustandsänderung wird als elektrische Größe eine kapazitive Impedanz der das elektrische Feld bildenden Metallschichten (111b; 112b) oder eine Änderung dieser Impedanz bestimmt.

3. Verfahren nach Anspruch 1 oder Anspruch 2 mit einem der folgenden zusätzlichen Schritte:
a. Bei dem Zustand handelt es sich um einen Ladezustand der elektrochemischen Energiespeichervorrichtung.
b. Bei dem Zustand handelt es sich um einen irregulären Zustand in Folge einer Temperaturerhöhung oder einer Gasung der elektrochemischen Energiespeichervorrichtung.
c. Bei dem Zustand handelt es sich um eine Temperatur der elektrochemischen Energiespeichervorrichtung.
d. Bei dem Zustand handelt es sich um den qualitativen Zustand einer Klebe- oder Siegelschicht (113) zwischen dem ersten und dem zweiten Gehäuseteil.
e. Bei dem Zustand handelt es sich um den qualitativen Zustand der Lagen (111c; 112c) aus Kunststoff der Verbundfolie des ersten oder des zweiten Gehäuseteils.

## Claims

1. Method of determining a state or a change of state of an electrochemical energy storage device (100), having the following features:
a. the energy storage device comprises a composite (101) composed of at least one positive electrode (102) in the form of a layer, at least one negative electrode (103) in the form of a layer and at least one separator layer (104),
b. the energy storage device comprises a housing composed of a multilaminar composite film,
c. the housing comprises a first and second housing portion (111; 112) composed of the multilaminar composite film that are joined to one another, preferably at their edges, and together enclose a cavity in which the composite (101) is disposed,
d. the composite film comprises one lamina of a metal layer (111b; 112b) and two laminas of plastic (111a, 111c; 112a, 112c), wherein the metal layer (111b; 112b) is disposed between the two plastic laminas (111a, 111c; 112a, 112c), and
e. the metal layer (111b) of the first housing portion (111) and the metal layer (112b) of the second housing portion (112) are electrically insulated from one another,
wherein
f. the state or change of state is determined by applying an electrical voltage to the metal layers (111b; 112b) of the first and second housing portions (111; 112) so as to result in an electrical field between the metal layers (111b; 112b), and determining an electrical parameter influenced by a change in the distance between the metal layers (111b; 112b).

2. Process according to Claim 1, having at least one of the following additional steps:
a. The state or change of state is determined by determining, as the electrical parameter, an electrical capacitance between the metal layer (111b) of the first housing portion and the metal layer (112b) of the second housing portion or a change in this capacitance.
b. The state or change of state is determined by determining, as the electrical parameter, an electrical voltage that exists between the metal layers (111b; 112b) or a change in this voltage.
c. The state or change of state is determined by determining, as the electrical parameter, a capacitive impedance of the metal layers (111b; 112b) that form the electrical field or a change in this impedance.

3. Process according to Claim 1 or Claim 2, having one of the following additional steps:
a. The state is a state of charge of the electrochemical energy storage device.
b. The state is an irregular state as a result of an increase in temperature or gassing of the electrochemical energy storage device.
c. The state is a temperature of the electrochemical energy storage device.
d. The state is the qualitative state of an adhesive layer or sealing layer (113) between the first and second housing portions.
e. The state is the qualitative state of the laminas (111c; 112c) made of plastic of the composite film of the first or second housing portion.

## Revendications

1. Procédé de détermination d'un état ou d'un changement d'état d'un dispositif accumulateur d'énergie électrochimique (100) présentant les caractéristiques suivantes
a. le dispositif accumulateur d'énergie comprend un composite (101) constitué d'au moins une électrode positive en couches (102), d'au moins une électrode négative en couches (103) et d'au moins une couche séparatrice (104),
b. le dispositif accumulateur d'énergie comprend un boîtier constitué d'un film composite multicouche,
c. le boîtier comprend des première et deuxième parties de boîtier (111 ; 112) constituées du film composite multicouche, qui sont reliées l'une à l'autre, de préférence au niveau de leurs bords, et qui renferment ensemble une cavité dans laquelle est disposé le composite (101),
d. le film composite comprend une couche constituée d'un métal (111b ; 112b) et deux couches de matière plastique (111a, 111c ; 112a, 112c), dans lequel la couche métallique (111b ; 112b) est disposée entre les deux couches de matière plastique (111a, 111c ; 112a, 112c), et
e. la couche métallique (111b) de la première partie de boîtier (111) et la couche métallique (112b) de la deuxième partie de boîtier (112) sont électriquement isolées l'une de l'autre,
dans lequel
f. pour déterminer l'état ou le changement d'état, une tension électrique est appliquée aux couches métalliques (111b ; 112b) des première et deuxième parties de boîtier (111 ; 112), de telle manière qu'un champ électrique soit produit entre les couches métalliques (111b ; 112b), et qu'une grandeur électrique, qui est influencée par une modification d'une distance entre les couches métalliques (111b ; 112b), soit déterminée.

2. Procédé selon la revendication 1, comprenant au moins l'une des étapes supplémentaires suivantes :
a. Pour déterminer l'état ou le changement d'état, une capacité électrique entre la couche métallique (111b) de la première partie du boîtier et la couche métallique (112b) de la deuxième partie du boîtier ou un changement de ladite capacité est déterminé en tant que grandeur électrique.
b. Pour déterminer l'état ou le changement d'état, une tension électrique présente entre les couches métalliques (111b ; 112b) ou un changement de ladite tension est déterminée en tant que grandeur électrique.
c. Pour déterminer l'état ou le changement d'état, une impédance capacitive des couches métalliques (111b ; 112b) créant le champ électrique ou un changement de ladite impédance est déterminé en tant que grandeur électrique.

3. Procédé selon la revendication 1 ou la revendication 2, comprenant l'une des étapes supplémentaires suivantes :
a. L'état est un état de charge du dispositif accumulateur d'énergie électrochimique.
b. L'état est un état irrégulier résultant d'une élévation de température ou d'un dégagement gazeux du dispositif accumulateur d'énergie électrochimique.
c. L'état est une température du dispositif accumulateur d'énergie électrochimique.
d. L'état est un état qualitatif d'une couche adhésive ou d'étanchéité (113) entre les premier et deuxième éléments de boîtier.
e. L'état est un état qualitatif des couches (111c ; 112c) de matière plastique du film composite des première ou de la deuxième partie de boîtier.
